# EUROPEAN PATENT SPECIFICATION

(11) **EP 1 426 780 B1**
(45) Date of publication and mention of the grant of the patent: **09.08.2006**
(21) Application number: 03257665.4
(22) Date of filing: 05.12.2003
(51) Int. Cl.: G01R 31/319

(54) **Semiconductor device with data ports supporting simultanous bi-directional data sampling and method for testing the same**
Halbleiter-Baustein mit Daten-Ports für simultanen bi-direktionalen Datenaustausch und Methode zum Testen desselben
Dispositif semi-conducteur avec port d'échange de données bi-directionel et procédé de test dudit dispositif

(30) Priority: 06.12.2002 KR 2002077348; 21.04.2003 US 421533
(43) Date of publication of application: 09.06.2004
(73) Proprietor: SAMSUNG ELECTRONICS CO., LTD., Suwon-si, Gyeonggi-do (KR)
(72) Inventor: Choi, Jung-hwan, Suwon-city Kyungki-do (KR)
(74) Representative: Greene, Simon Kenneth

(56) References cited:
- EP-A- 0 838 689
- US-A1- 2002 079 926
- US-B1- 6 272 657
- PATENT ABSTRACTS OF JAPAN vol. 1995, no. 10, 30 November 1995 (1995-11-30) & JP 7 181227 A (KAWASAKI STEEL CORP), 21 July 1995 (1995-07-21)

## Description

The present invention relates to semiconductor devices employing simultaneous bi-directional transmission, and methods and apparatus for testing such devices.

Semiconductor devices such as processors, controllers, memory devices, etc., are commonly equipped with data transceivers that allow them to receive and transmit digital signals. Conventionally, such transceivers are reconfigurable to either receive or transmit data across an attached transmission line. Recently, devices with *simultaneous bi-directional* (SBD) transmit/receive capability have received increased interest. As the name alludes to, SBD transceivers have the capability to receive and transmit digital data during the same clock cycle, on the same transmission line.

US 2002/0079926, Haycock et al, discloses a SBD input/output (I/O) circuit which includes a first multiplexer (MUX) in the reference select circuitry and a second, matching MUX in the pre-driver stage of the output buffer. Also, described are an electronic system, a data processing system, and various methods of testing SBD I/O circuits.

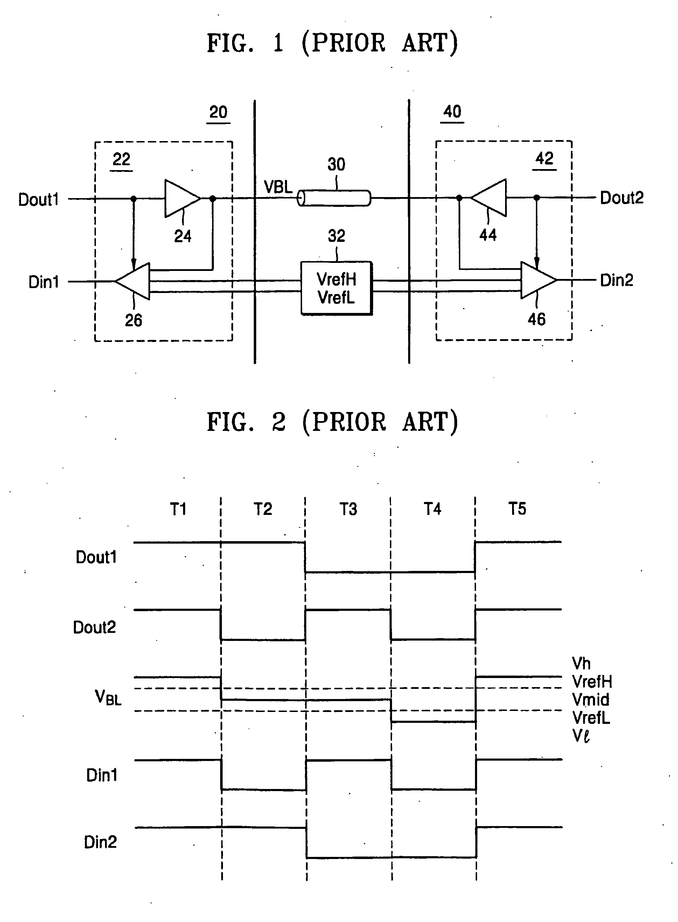

Figure 1 shows a conventional SBD connection between two semiconductor devices 20 and 40. Devices 20 and 40 contain, respectively, SBD transceivers 22 and 42. SBD transceiver 22 contains a data driver 24 and a data receiver 26. An internal data signal to be driven, Dout1, is supplied as an input to driver 24 and as a control signal to receiver 26. The output of driver 24 is coupled to the input of receiver 26. Receiver 26 also receives two reference voltages, *VrefH* and *VrefL*, which it uses for comparisons, as will be explained shortly. The output of receiver 26 is a data input, Din1, to device 20.

Transceiver 42 of device 40 is preferably matched to transceiver 22 of device 20. Transceiver 42 contains a driver 44 and a receiver 46 connected in an identical configuration as the driver and receiver of transceiver 22. Driver 44 takes its input from an internal data signal Dout2, and receiver 46 generates a data input Din2.

Semiconductor devices 20 and 40 can be connected to each other in the configuration shown in Figure 1, by connecting the outputs of drivers 24 and 44 to a transmission line 30. Note that in this configuration, the drive state of both driver 24 and driver 44 determine the bit line voltage *V*_{*BL*} on transmission line 30. A common reference voltage generator 32 supplies *VrefH* and *VrefL* to both circuits.

Figure 2 contains waveforms illustrating the simultaneous exchange of data between devices 20 and 40 over transmission line 30. Dout1 is high duringtime periods T1, T2, and T5. Dout2 is high during time periods T1, T3, and T5. Consequently, during T1, drivers 24 and 44 both pull the bit line voltage *V*_{*BL*} high, e.g., to an upper rail voltage *V*_{*h*}. During T2, driver 24 attempts to pull bit line voltage *V*_{*BL*} high and driver 44 attempts to pull *V*_{*BL*} low, e.g., to a lower rail voltage *V*_{*l*}. With matched drivers, *V*_{*BL*} will assume an approximate voltage *V*_{*mid*}, halfway between upper rail voltage *V*_{*h*} and the lower rail voltage *V*_{*l*}. During T3, both drivers reverse, and *V*_{*BL*} stays at *V*_{*mid*}. During T4, both drivers pull *V*_{*BL*} low, to *V*_{*l*}*.*

Receivers 26 and 46 determine the drive state of the other device's driver during each time period by selecting an appropriate comparison voltage, based on the known drive state of their own driver. For instance, during T1 and T2, receiver 26 knows that driver 24 is driving line 30 high―thus the only two possible values of *V*_{*BL*} are *V*_{*h*} (if driver 44 is also driving line 30 high) and *V*_{*mid*} (if driver 44 is driving line 30 low). Thus during T1 and T2, receiver 26 compares *V*_{*BL*} to *VrefH*, which is midway between *V*_{*h*} and *V*_{*mid*}, and is able to determine that driver 44 was sending a high voltage during T1 and a low voltage during T2. Similarly, during T3 and T4, receiver 26 knows that driver 24 is driving line 30 low, and compares *V*_{*BL*} to *VrefL*. Receiver 46 operates similarly, but based on the known state of driver 44, to determine the drive state of driver 24.

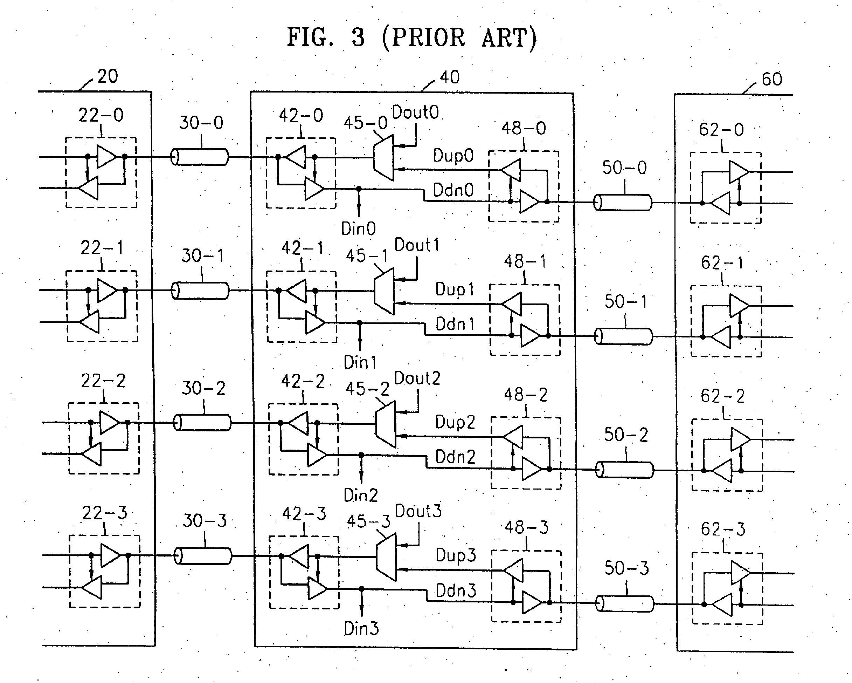

One use of SBD transmission technology is in a point-to-point memory system such as in the partial system depicted in Figure 3. In such a memory system, devices can communicate with an *upstream* device and a *downstream* device over separate connections. For instance, device 20 can be a memory controller, and devices 40 and 60 can be two memory devices connected to the controller. As the controller initiates memory operations, it is upstream of device 40. And as device 40 is interposed between devices 60 and 20, device 40 is upstream of device 60. Address and control signal buses used to control memory operations are not shown in Figure 3.

Although such a configuration can have any practicable data bus width, Figure 3 shows a bus width of four bits. One bus consists of point-to-point bit lines 30-0, 30-1, 30-2, and 30-3, with device 20 as an upstream device and device 40 as a downstream device: A second bus consists of point-to-point bit lines 50-0, 50-1, 50-2, and 50-3, with device 40 as an upstream device and device 60 as a downstream device.

Device 40 has an upstream port consisting of four upstream SBD transceivers 42-0, 42-1, 42-2, and 42-3, and a downstream port consisting of four downstream SBD transceivers 48-0, 48-1, 48-2, and 48-3. Within device 40, upstream SBD transceiver is connected to a corresponding downstream SBD transceiver. Thus data received, e.g., at transceiver 42-0, is both a data input Din0 to device 40 and an input Ddn0 to the downstream driver of transceiver 48-0. And data Dup0 received, e.g., at transceiver 48-0, is multiplexed with device 40 output data Dout0 at a multiplexer 45-0, for input to the upstream driver of transceiver 42-0.

Devices 20 and 40 communicate *n* bits of SBD data as previously described, with the bit lines 30-*n* working in parallel. Depending on the memory operation, however, the data received by device 40 may be destined either for device 40 or for a downstream device (e.g., device 60), and the data transmitted by device 40 may be either internal data or data received from device 60. Thus devices 20 and 60 communicate data between each other using their respective point-to-point buses to device 40, and device 40 forwards data traffic between its upstream and downstream ports in a pass mode.

In a first aspect of the invention there is provided a method of testing a device configuration as set out in claim 1.

In another aspect, there is provided a semiconductor device as set out in claim 12.

The method and device provide for the testing of simultaneous bidirectional transmission devices.
Figure 1 illustrates two prior-art SBD transceivers, on separate semiconductor devices, connected by a transmission line;
Figure 2 illustrates data input value/output value relationships for the transceivers of Figure 1;
Figure 3 shows a prior art semiconductor device with a pass-through data port, allowing the device to connect two other devices over point-to-point data buses;
Figure 4 is a block diagram for a semiconductor device according to an embodiment of the invention;
Figures 5A and 5B show device testing configurations according to an embodiment of the invention, for two communicating SBD devices;
Figures 6A and 6B show device testing configurations according to an embodiment of the invention, for three communicating SBD devices;
Figure 7 shows a device configuration according to an embodiment of the invention, for five communicating SBD devices;
Figures 8A and 8B show a second set of device testing configurations according to an embodiment of the invention, for two communicating SBD devices; and
Figures 9A, 9B, and 9C show device testing configurations according to an embodiment of the invention, for one SBD device.

Generally, automatic test equipment (ATE) is used to cull bad semiconductor devices from a lot of semiconductor devices. An ATE station is connected to a device to be tested via a a test board. The ATE station is programmable, such that it can be configured to apply test signals to the inputs of a device under test (DUT), and receive signals from the outputs of the DUT. For instance, if the DUT is a memory device, the ATE station might emulate memory controller address and control signaling to write a certain bit pattern to the memory device, and then read the bit pattern back to see if what was written was stored and retrieved successfully.

Conventional ATE stations do not support SBD transfers. Even if such stations supported SBD transfers, the stations would have to use SBD transceivers that were matched to the SBD transceivers of a DUT, or else SBD transfers would be error-prone or impossible. Accordingly, it is desirable that test communications between an ATE station and a DUT remain unidirectional, even for DUTs with SBD data ports. And yet the SBD capability of a DUT is critical to device operation, and must be tested.

The described embodiments provide for testing of SBD devices, including the SBD capability of such devices, in an environment that allows for unidirectional communication between a device configuration under test and an ATE station. As will be illustrated, the invention encompasses various methods for testing such a device configuration, integrated circuit test boards, and semiconductor devices amenable to testing using the described methods and test boards. One concept found throughout these embodiments is an ability to configure an SBD semiconductor device such that two data port pads can be used in a test mode to respectively receive one unidirectional data signal and transmit another unidirectional data signal, with these two data signals coupled respectively to/from a third pad that operates as an SBD pad. This concept will be clarified as the following embodiments are explored in detail.

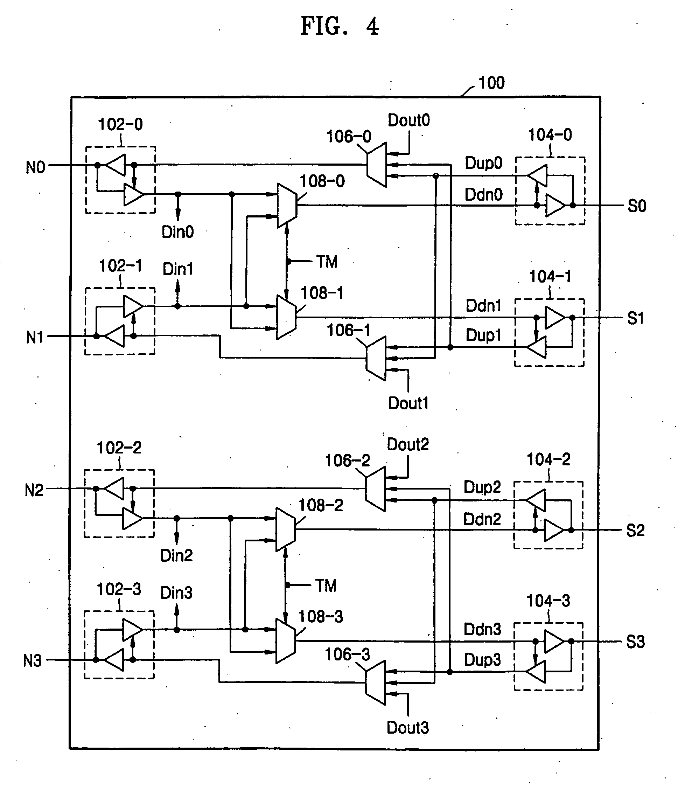

Figure 4 illustrates a semiconductor device 100 according to one embodiment of the present invention. A north, or upstream, SBD data port comprises pads N0, N1, N2, and N3, connected respectively to SBD transceivers 102-0, 102-1, 102-2, and 102-3. A south, or downstream, SBD data port comprises pads S0, S1, S2, and S3, connected respectively to SBD transceivers 104-0, 104-1, 104-2, and 104-3. Like in prior art devices, data input to the device and data output from the device utilizes the north or upstream port in a normal mode. A pass mode uses a pass-through path that connects the north port with the south port in a one-to-one pad correspondence, e.g., transceiver 102-0 is connected to transceiver 104-0, transceiver 102-1 is connected to transceiver 104-1, etc. But unlike in the prior art devices, this path is not fixed―at least one second pad correspondence is possible that is useful for testing, and is activated in a test mode.

Multiple pass-through paths are possible with device 100 due to the inclusion of cross-connecting switching elements that allow different correspondences between north and south port pads. Significantly for unidirectional test signaling, the switching elements can be configured to pass data in various two-pad-to-one-pad mappings. For instance, consider pads N0, N1, S0, and S1. Transceivers 102-0 and 102-1 both supply received signals to multiplexers (MUXs) 108-0 and 108-1. A test mode signal TM determines which input forms the output for each MUX. Thus either Din0 or Din1 can be selected as signal Ddn0, to be driven externally by transceiver 104-0. Likewise, either Din0 or Din1 can be selected as signal Ddn1, to be driver externally by transceiver 104-1.

Similarly, MUXs 106-0 and 106-1 determine one of multiple sources to be driven externally by transceivers 102-0 and 102-1, respectively. MUX 106-0, e.g., can select between Dup0, Dup1, and Dout0 (output data supplied from the chip core).

A similar switching element arrangement connects north port pads N2 and N3 with south port pads S2 and S3. For devices with larger bus widths, the switching element configuration can be repeated for each set of two north and two south ports. Note that although multiplexers are illustrated in Figure 4 as the switching elements, individual switches can accomplish the same functionality, or a subset of this functionality.

With the preceding description of a semiconductor device embodiment in place, several device configurations will now be shown and described. Each of these device configurations allows some (or all) SBD pads of a DUT to be exercised in SBD mode as an internal SBD port, using other SBD pads as an external unidirectional port.

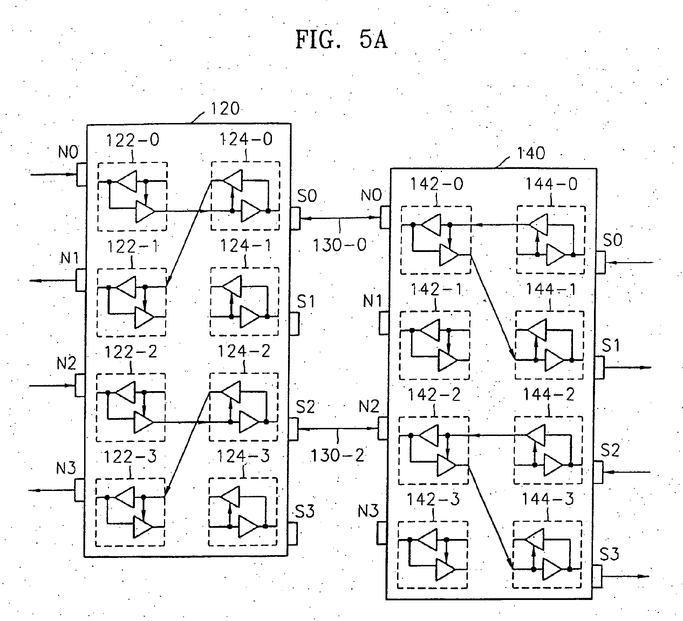

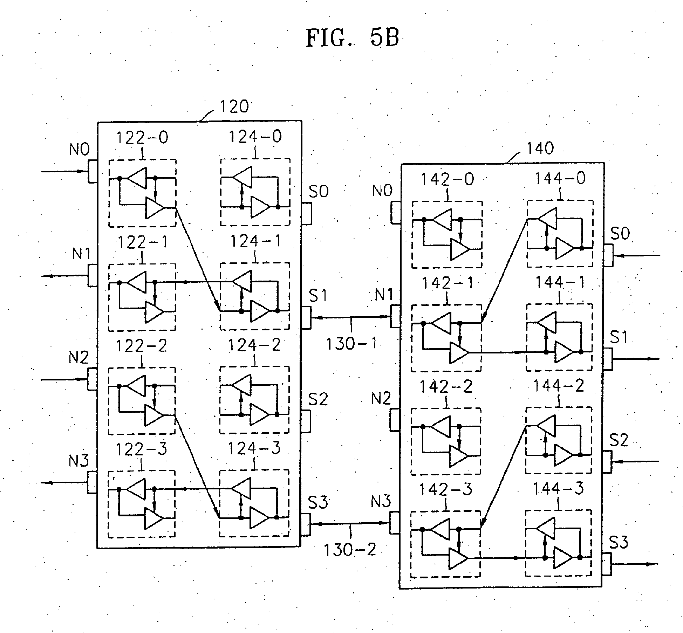

Figures 5A and 5B illustrate a first device configuration consisting of semiconductor devices 120 and 140. The external data port consists of the north port of device 120 and the south port of device 140. The even-numbered port pads N0 and N2 (device 120) and S0 and S2 (device 140) are configured as a receive port to receive data from an attached tester (not shown). The odd-numbered port pads N1 and N3 (device 120) and S1 and S3 (device 140) are configured as a transmit port to send data to the attached tester.

Two internal data ports are shown. The first internal data port consists of the south port pads of device 120, and the second internal data port consists of the north port pads of device 140. The port pads of the first and second internal data ports are connected by a test board in a one-to-one correspondence, e.g., device 120 port pad S0 connects to device 140 port pad N0 via a bit line 130-0 formal in/on the test board.

In test mode, two test phases are used to conduct an SBD test of the internal data ports. In the first phase, internal data paths in device 120 and 140 are set as shown in Figure 5A. In the second phase, internal data paths are set as shown in Figure 5B. Each phase will be explained in turn.

In the first phase, the even-numbered south port pads of device 120 and the even-numbered north port pads of device 140 are tested. Thus in device 120, the internal data paths are configured to pass write data received at N0 and N2, respectively, to S0 and S2 and pass write data received at S0 and S2, respectively, to N1 and N3. In device 140, the internal data paths are configured to pass write data received at S0 and S2, respectively, to N0 and N2 and pass write data received at N0 and N2, respectively, to S1 and S3. This configuration can be done, e.g., by having the ATE set test mode fields in the mode register sets of devices 120 and 140, to configure switching elements such as those shown in Figure 4.

Once the data path configuration is complete, the ATE writes bit patterns to the designated external port write pads to test the SBD capability of the internal port. For instance, logic zero can be written to device 120 port pads N0 and N2, at the same time that logic one is written to device 140 port pads S0 and S2. This causes transceiver 124-0 to drive a logic zero on bit line 130-0 at the same time that transceiver 142-0 drives a logic one on the same bit line. If transceivers 124-0 and 142-0 are operating correctly, transceiver 124-0 will receive a logic one and transceiver 142-0 will receive a logic zero. The values received by transceivers 124-0 and 142-0 will be internally forwarded to transceivers 122-1 and 144-1, respectively, and driven to the ATE from device 120 port pad N1 and device 140 port pad S1.

As the ATE will normally also exercise the SBD capability for the opposite signal polarity to that just described, the ATE then repeats the above write/read process with a different bit pattern, e.g., logic one written to device 120 port pads N0 and N2 and logic zero written to device 140 port pads S0 and S2. This causes, e.g., transceiver 124-0 to write a logic one and read a logic zero, and transceiver 142-0 to write a logic zero and read a logic one.

Because in this configuration the number of external port unidirectional-mode pads is equal to the number of internal port SBD pads, only half of the SBD pads can be tested simultaneously. The second phase, illustrated in Figure 58, tests the other half of the internal port SBD pads. Referring to Figure 5B, in device 120, the internal data paths are reconfigured to pass write data received at N0 and N2, respectively, to S1 and S3 and pass write data received at S 1 and S3, respectively, to N1 and N3. In device 140, the internal data paths are configured to pass write data received at S0 and S2, respectively, to N1 and N3and pass write data received at N1 and N3, respectively, to S1 and S3. This configuration can be done, e.g., by having the ATE set test mode fields in the mode register sets of devices 120 and 140 to cause a switch from the configuration of Figure 5A to the configuration of Figure 5B.

Once the test path reconfiguration is complete, the ATE repeats the previous write/read bit pattern test to test the odd SBD pads S1 and S3 on device 120 and N1 and N3 on device 140. Although only two bit patterns have been described for each phase of the test, those skilled in the art recognize that a variety of bit patterns can be attempted, in varying sequences, during a test.

Assuming that the devices pass the described test, the south port on device 120 and the north port on device 140 have been verified as operational in SBD mode. If both devices are DUTs, swapping device positions in the device configuration and repeating the test can test their other ports. Alternately, one device can be a known good device (KGD). The other device is the device under test, and is fully tested by testing it first in the position of device 120, with a KGD at device 140, and then in the position of device 140, with a KGD at device 120.

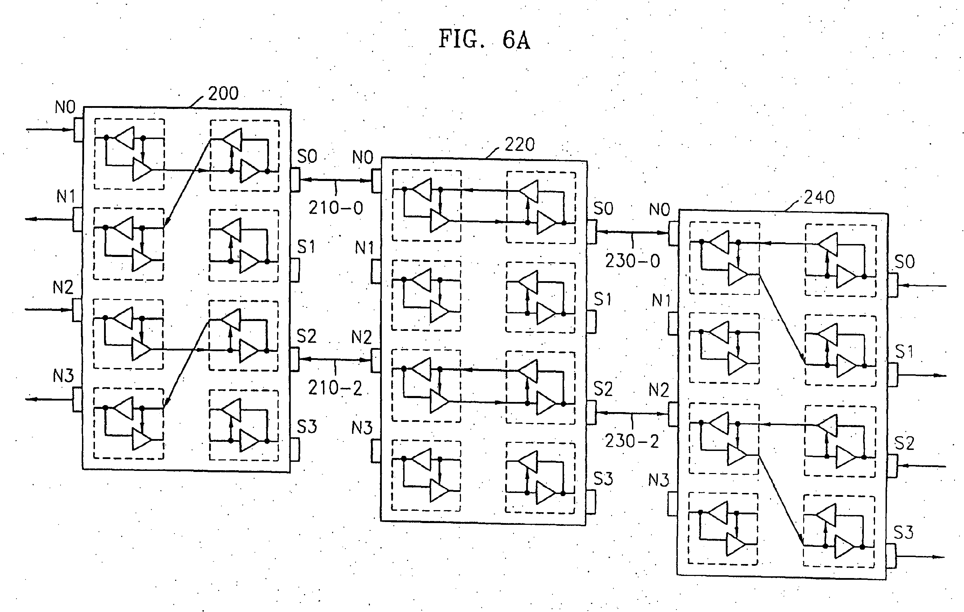

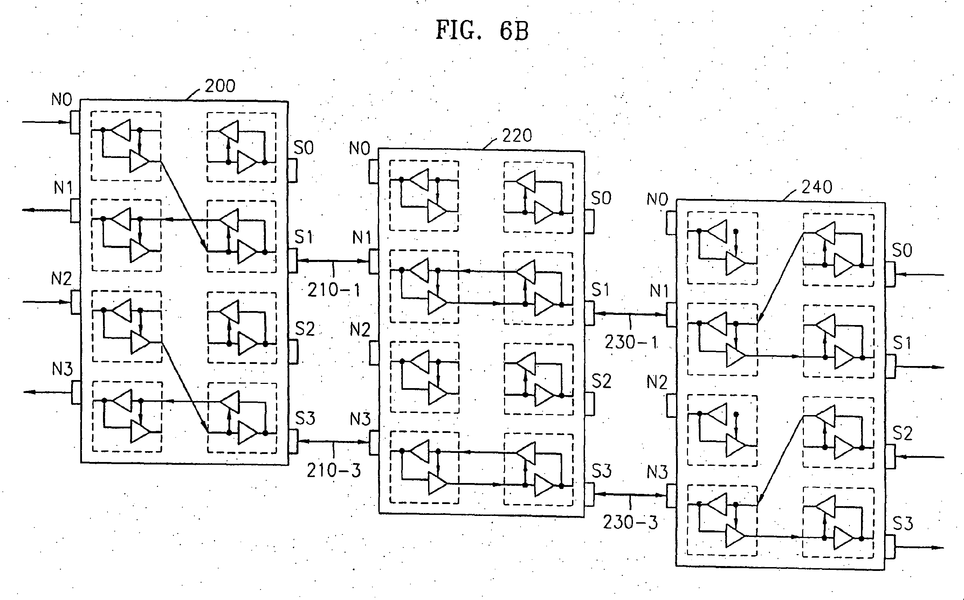

Figures 6A and 6B illustrate a second device configuration consisting of semiconductor devices 200, 220, and 240. The external data ports consist of the north port pads of device 200 and the south port pads of device 240. The even-numbered port pads N0 and N2 (device 200) and S0 and S2 (device 240) are configured as receive ports to receive data from an attached tester (not shown). The odd-numbered port pads N1 and N3 (device 200) and S1 and S3 (device 240) are configured as transmit ports to send data to the attached tester.

Four internal data ports exist in the Figure 6A configuration. The four internal data ports are: the south port of device 200; both the north and south ports of device 220; and the north port of device 240. The south port pads of device 200 and the north port pads of device 220 are connected by a test board in a one-to-one correspondence, e.g., device 200 port pad S0 connects to device 220 port pad N0 via a bit line 210-0. The south port pads of device 220 and the north port pads of device 240 are connected in a one-to-one correspondence as well, e.g., device 220 port pad S0 connects to device 240 port pad N0 via a bit line 230-0.

Like in the previous example, two test mode phases are used to conduct an SBD test of the internal data ports. In the first phase, internal data paths are set as shown in Figure 6A. In the second phase, internal data paths are set as shown in Figure 6B. Each phase will be explained in turn.

In the first phase, the even-numbered internal ports are tested. Devices 200 and 240 are configured respectively like devices 120 and 140 in Figure 5A. Device 220 is configured in a straight pass-through configuration, e.g., port pad N0 communicates bi-directionally with port pad S0, etc. This configuration can be done, e.g., by having the ATE set test mode fields in the mode register sets of devices 200 and 240 (the device 220 configuration may not be a test configuration, but could be).

Once the data path configuration is complete, the ATE proceeds with bit pattern testing as in the prior example to test the even-numbered port pads of the four internal data ports. The path difference from the prior example is internal to the configuration, as the data will pass through one more point-to-point bus than in the prior example. Once bit pattern testing is complete for this configuration, the ATE proceeds to configure devices 200 and 240 in the configuration shown in Figure 6B (like the respective configuration of devices 120 and 140 of Figure 5B) to test the odd-numbered internal port pads, as in the previous example.

At the end of the test cycle, the SBD capability of device 220 has been fully tested. If devices 200 and 240 are KGDs, another candidate device can replace device 220 and the test cycle can be repeated. Alternately, if all devices are DUTs, devices 200 and 240 can be swapped, and a new candidate device inserted in the place of device 220, and the test cycle repeated. This procedure fully tests the SBD capability of device 200, the original and second devices 220, and the device 240, in two test cycles.

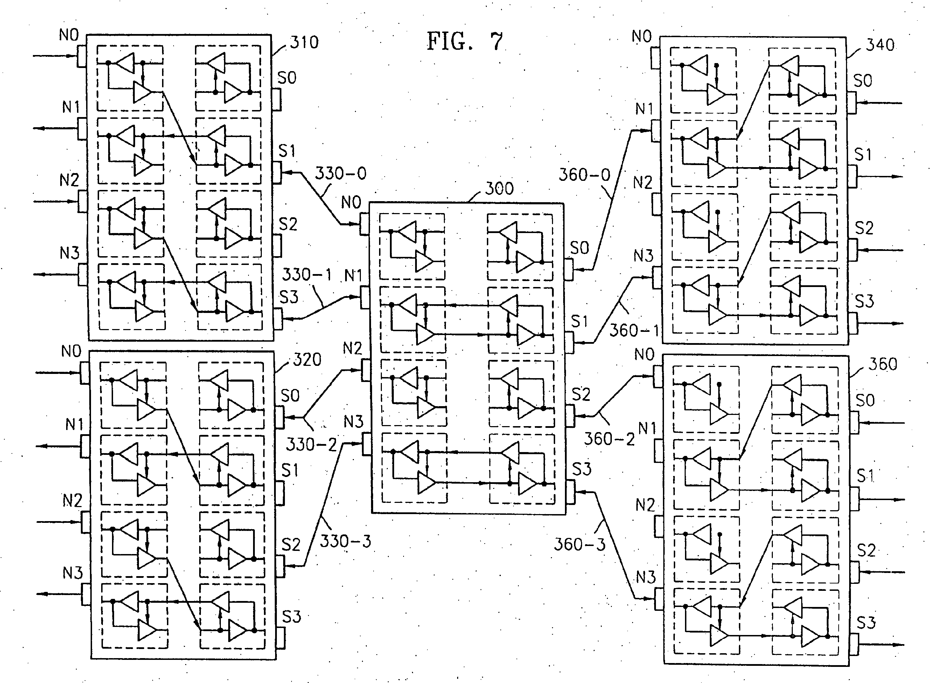

Figure 7 illustrates a third device configuration consisting of five semiconductor devices 300, 310, 320, 340, and 350. The external data ports consist of the north port pads of devices 310 and 320 and the south port pads of devices 340 and 350. The even-numbered port pads N0 and N2 (devices 310 and 320) and S0 and S2 (devices 340 and 350) are configured as receive ports to receive data from an attached tester (not shown). The odd-numbered port pads N1 and N3 (devices 310 and 320) and S1 and S3 (devices 340 and 350) are configured as transmit ports to send data to the attached tester.

Six internal data ports exist in the Figure 7 configuration. The six internal data ports are: the south port of devices 310 and 320; both the north and south ports of device 300; and the north port of devices 340 and 350. Half of the south port pads of devices 310 and 320, respectively, connect to respective halves of the north port pads of device 300, e.g.: device 310 port pad S 1 connects to device 300 port pad N0 via a bit line 330-0; device 310 port pad S3 connects to device 300 port pad N1 via a bit line 330-1; device 320 port pad S0 connects to device 300 port pad N2 via a bit line 330-2; and device 320 port pad S2 connects to device 300 port pad N3 via a bit line 330-3. Similar connections connect half of the north port pads of devices 340 and 350, respectively, to respective halves of the south port pads of device 300, via bit lines 360-0, 360-1, 360-2, and 360-3.

In this example, twice as many external port pads are available as in the previous examples. Accordingly, all of the port pads of device 300 can be tested simultaneously. The data signal input at N0 on device 310, e.g., passes through to port pad S1, is driven to port pad N0 on device 300, passes through to port pad S0, is driven to port pad N1 on device 340, passes through to port pad S 1, and is driven to the ATE. At the same time, another data signal input at S0 on device 340 passes through to port pad N1, crosses the first data signal on bit lines 360-0 and 330-0 to port pad S1 on device 310, passes through to port pad N1, and is driven to the ATE. Other ATE inputs and outputs cross similarly for the other external and internal port pads.

One use of the configuration shown in Figure 7 is with KGD devices for all devices except device 300. Note that half of the internal ports on all KGDs are still available, and could be connected to a second test socket and used to test a second DUT in a similar manner to device 300.

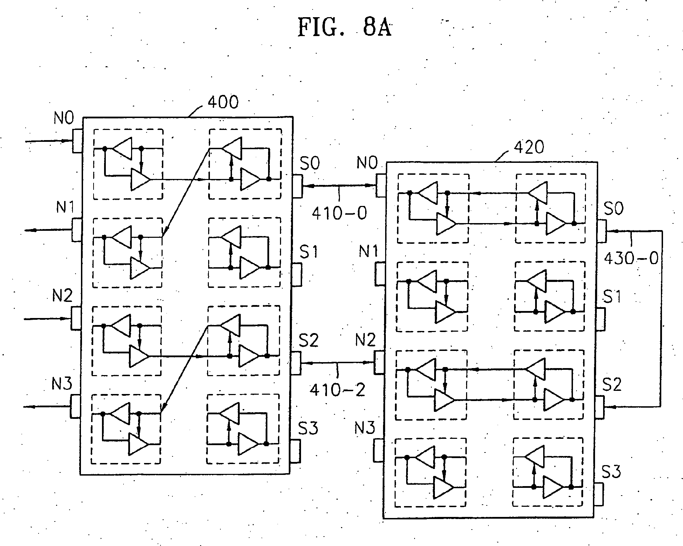

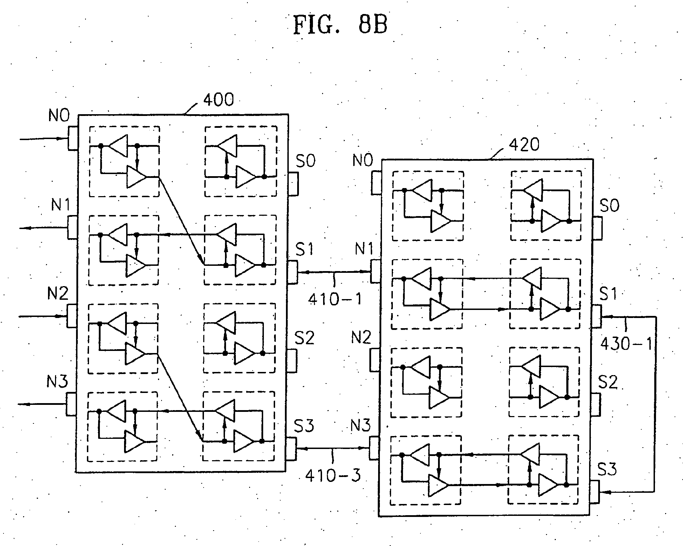

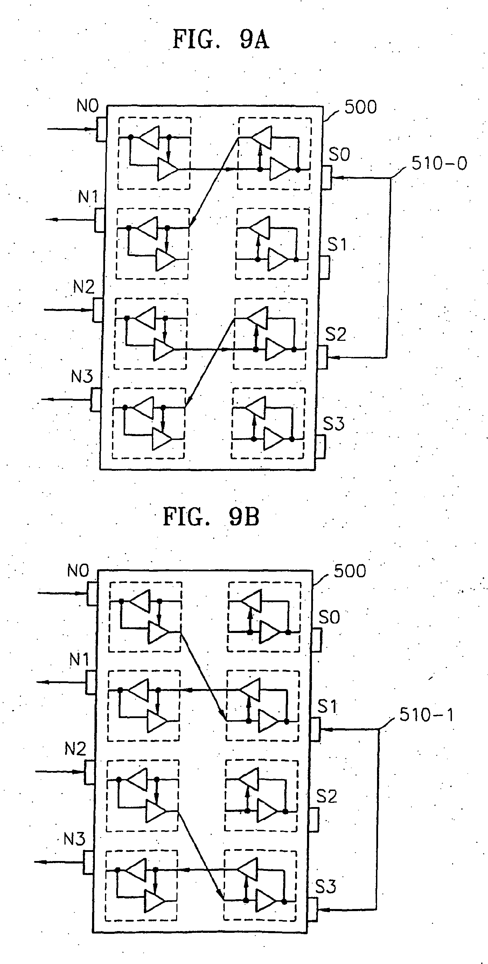

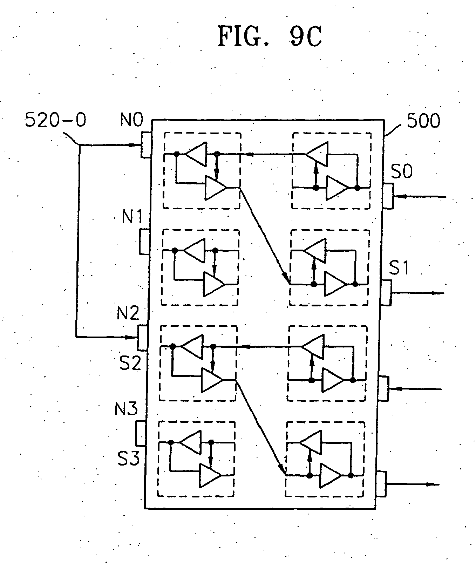

It is generally preferred to test the SBD capability of a DUT using either other DUTs or KGDs. It is possible, however, to construct device configurations where some DUT SBD port pads are paired with other SBD port pads on the same DUT. Figures 8A and 8B show one such configuration; Figures 9A, 9B, and 9C show another.

Figure 8A, like Figure 5A, shows a two-device test configuration. In the Figure 8A configuration, however, the only external port is the north port of device 400. Device 400 port pads N0 and N2 receive data signals from an attached ATE; device 400 port pads N1 and N3 transmit data signals to an attached ATE.

In Figure 8A, three internal SBD ports are present. The south port of device 400 connects with the north port of device 420 in a one-to-one port pad correspondence, e.g., device 400 port pad S0 connects to device 420 port pad N0 via a bit line 410-0, etc. The south port of device 420 connects to itself―port pad S0 connects to port pad S2 via a bit line 430-0, and port pad S1 connects to port pad S3 via a bit line 430-1.

Two test phases are used to test the SBD capability of device 420. In the first test phase, the ATE transmits a first data signal to device 400 port pad N0 and a second data signal to device 400 port pad N2. The first data signal is internally routed to device 400 port pad S0, driven on bit line 410-0 to device 420 port pad N0, internally routed to device 420 port pad S0, driven on bit line 430-0 to device 420 port pad S2, internally routed again to device 420 port pad N2, driven on bit line 410-2 to device 400 port pad S2, internally routed to device 400 port pad N3, and driven to the ATE. Simultaneously, the second data signal is internally routed to device 400 port pad S2, driven in the opposite direction on bit lines 410-2, 430-0, and 410-0 to reach device 400 port pad S0, internally routed to device 400 port pad N1, and driven to the ATE.

In the second test phase, the internal data paths of device 400 are reconfigured as shown in Figure 8B, such that device 400 port pads S 1 and S3 are the active SBD pads of device 400. Test bit patterns are driven once again to device 400, this time testing the port pads connected to bit lines 410-1, 430-1, and 410-3.

After the second test phase, all port pads of device 420 have been tested for SBD capability.

One additional test device configuration set is illustrated in Figures 9A, 9B, and 9C. This configuration pair contains a single device, the DUT. In Figures 9A and 9B, the north port of device 500 is used for unidirectional communication with an ATE, and the south port of device 500 connects to itself to form the internal port. In Figure 9C, the south port and north port of device 500 switch roles.

Four test phases are required to test all SBD port pads. Figure 9A illustrates the first test phase. In the first test phase, the ATE transmits a first data signal to device 500 port pad N0 and a second data signal to device 500 port pad N2. The first data signal is internally routed to device 500 port pad S0, driven on bit line 510-0 to device 500 port pad S2, internally routed to device 500 port pad N3, and driven to the ATE. Simultaneously, the second data signal is internally routed to device 500 port pad S2, driven in the opposite direction on bit line 510-0 to reach device 500 port pad S0, internally routed to device 500 port pad N1, and driven to the ATE.

In the second test phase, the internal data paths of device 500 are reconfigured as shown in Figure 9B, such that device 500 port pads S 1 and S3 are the active SBD pads of the device. Test bit patterns are driven once again to device 400, this time testing the port pads connected to bit lines 510-1.

To test the SBD capability of the north ports, the third and fourth test phases use a device configuration (the third test phase is shown in Figure 9C) that switches the roles of the north and south ports from that of Figures 9A and 9B. During the third test phase, bit line 520-0 tests SBD capability between device 500 port pads N0 and N2. During the fourth test phase, a bit line (not shown) between port pads N1 and N3 is tested.

Those skilled in the art will recognize that many other device configuration permutations can be envisioned. For example, two serial DUTs could occupy the position of device 220 (Figure 6A) or device 300 (Figure 7). Most devices will have data port widths much larger than the four bits illustrated―the connection patterns shown can merely be repeated for each additional four-bit width at each port. Other alternate internal device cross-connection patterns and device-to-device port pad assignments are feasible, although it is believed that the simplest device layouts will generally result from pairing adjacent port pad circuitry.

Explicit instructions for construction of test boards for use with the described embodiments have been omitted. It is believed that given the device-to-device routing illustrations presented, the layout of such a test board is well within the skill of those in the applicable art.

Although the focus of the preceding description has been on SBD testing, embodiments of the present invention can be used in some instances for all testing of a DUT with a unidirectional ATE connection.

## Claims

1. A method of testing a device configuration having an external data port and at least one internal data port, wherein each device (100) comprises cross-connecting switching elements, each data port comprises at least four pads (N0-N3, S0-S3), with their corresponding bi-directional buffers (102-0,102-1,102-2,102-3,104-0,104-1,104-2,104-3), and wherein the pads of the external and internal data ports support simultaneous bi-directional, SBD, data signaling, the method comprising:
connecting the pads of the external data port to communicate with a tester using unidirectional data signaling;
connecting at least one first internal data port pad to a second internal data port pad; and
setting internal data paths in at least one device of the device configuration to concurrently:
route a first write signal received on a first external data port pad to an output driver of the first internal data port pad,
route a second write signal received on a second external data port pad to an output driver of the second internal data port pad
, route a signal received by a receiver of the first internal data port pad to a third external data port pad as a first read signal, and
route a signal received by a receiver of the second internal data port pad to a fourth external data port pad as a second read signal.

2. The method of claim 1, further comprising connecting at least one third internal data port pad to a fourth internal data port pad, and, after routing the first and second write signals, setting internal data paths in at least one device of the device configuration to concurrently:
route a third write signal received on the first external data port pad to an output driver of the third internal data port pad;
route a fourth write signal received on the second external data port pad to an output driver of the fourth internal data port pad;
route a signal received by a receiver of the third internal data port pad to the third external data port pad as a third read signal; and
route a signal received by a receiver of the fourth internal data port pad to the fourth external data port pad as a fourth read signal.

3. The method of claim 1 or 2, further comprising connecting at least one third internal data port pad to a fourth internal data port pad, and, as part of setting the internal data path, setting internal data paths in at least one device of the device configuration to concurrently:
route a third write signal received on a fifth external data port pad to an output driver of the third internal data port pad;
route a fourth write signal received on a sixth external data port pad to an output driver of the fourth internal data port pad;
route a signal received by a receiver of the third internal data port pad to a seventh external data port pad as a third read signal; and
route a signal received by a receiver of the fourth internal data port pad to an eighth external data port pad as a fourth read signal.

4. The method of any preceding claim, wherein the device configuration comprises a single device-under-test, DUT, having first and second simultaneous bi-directional, SBD, ports:
wherein the first SBD port is designated as the external data port and the second SBD port is designated as the internal data port; and
wherein connecting at least one first internal data port pad to a second internal data port pad comprises externally connecting half of the port pads of the second SBD port respectively to the other half of the port pads of the second SBD port, in a configuration such that no two port pads internally connectable to the same first SBD port are externally connected.

5. The method of any preceding claim, wherein the device configuration comprises first and second devices (120,140), each having first and second simultaneous bi-directional, SBD, ports:
wherein the first device (120) first SBD port and the second device (140) second SBD port are designated as the external data port, and the first device (120) second SBD port and the second device(140) first SBD port are designated respectively as first and second internal data ports;
wherein connecting at least one first internal data port pad to a second internal data port pad comprises interconnecting the pads of the first internal data port, respectively, with the pads of the second internal data port; and
wherein setting internal data paths in the device configuration comprises configuring the first and second devices such that the first and third external data port pads are associated with the first device (120) first SBD port, the second and fourth external data port pads are associated with the second device (140) second SBD port, the first internal data port pad is associated with the first internal data port, and the second internal data port pad is associated with the second internal data port.

6. The method of claim 5, further comprising swapping at least one of the first and second devices (120,140) to the position of the other device in the device configuration and repeating the steps of claim 5.

7. The method of claim 5, further comprising swapping the positions of the first and second devices (120,140) in the device configuration and repeating the steps of claim 5.

8. The method of any preceding claim, wherein the device configuration comprises first and second devices (120,140), each having first and second simultaneous bi-directional, SBD, ports, wherein the first device (120) is a known good device, KGD, and the second device (120) is a device under test, DUT,:
wherein the KGD first SBD port is designated as the external data port, and the KGD second SBD port and the DUT first and second SBD ports are designated respectively as first, second, and third internal data ports;
wherein connecting at least one first internal data port pad to a second internal data port pad comprises interconnecting the pads of the first internal data port, respectively, with the pads of the second internal data port, and externally connecting half of the port pads of the third internal data port respectively to the other half of the port pads of the third internal data port, in a configuration such that no two port pads internally connectable to the same second internal data port pad are externally connected; and
wherein setting internal data paths in the device configuration comprises configuring the first and second devices (120,140) such that the first write signal passes from the first external data port pad through a first pad of the first internal data port to a first pad of the second internal data port, through a first pad of the third internal data port to a second pad of the third internal data port, through a second pad of the second internal data port to a second pad of the first internal data port, and exits the fourth external data port pad as the second read signal, and the second write signal passes from the second external data port pad through the second pad of the first internal data port to the second pad of the second internal data port, through the second pad of the third internal data port to the first pad of the third internal data port, through the first pad of the second internal data port to the first pad of the first internal data port, and exits the third external data port pad as the first read signal.

9. The method of any of claims 1 to 7, wherein the device configuration comprises first and second known good devices, KGDs, and one device under test, DUT, each having first and second simultaneous bi-directional, SBD, ports:
wherein the first KGD first SBD port and second KGD second SBD port are designated as the external data port, and the first KGD second SBD port, the DUT first and second SBD ports, and the second KGD first SBD port are designated respectively as first, second, third, and fourth internal data ports;
wherein connecting at least one first internal data port pad to a second internal data port pad comprises interconnecting the pads of the first internal data port, respectively, with the pads of the second internal data port, and interconnecting the pads of the third internal data port, respectively, with the pads of the fourth internal data port; and
wherein setting internal data paths in the device configuration comprises configuring the KGDs and the DUT such that the first write signal passes from a first external data port pad on the first KGD, through a first pad of the first internal data port to a first pad of the second internal data port, through a first pad of the third internal data port to a first pad of the fourth internal data port, and exits through a fourth external data port pad on the second KGD as the second read signal, and the second write signal passes from a second external data port pad on the second KGD, through the first pad of the fourth internal data port to the first pad of the third internal data port, through the first pad of the second internal data port to the first pad of the first internal data port, and exits the third external data port pad on the first KGD as the first read signal.

10. The method of claim 9, wherein the method simultaneously tests half of the pads of the second and third internal ports, the method further comprising internally reconfiguring at least the data paths of the first and second KGDs to simultaneously test the other half of the pads of the second and third internal ports.

11. The method of any of claims 1 to 7, wherein the device configuration comprises first, second, third, and fourth KGDs and one DUT, each having first and second SBD ports:
wherein the first KGD first SBD port, second KGD first SBD port, third KGD second SBD port, and fourth KGD second SBD port are designated as the external data port, and the first KGD second SBD port, second KGD second SBD port, DUT first and second SBD ports, third KGD first SBD port, and fourth KGD first SBD port are designated respectively as first, second, third, fourth, fifth, and sixth internal data ports;
wherein connecting at least one first internal data port pad to a second internal data port pad comprises interconnecting half of the pads of the first internal data port, respectively, with half of the pads of the third internal data port, interconnecting half of the pads of the second internal data port to the other half of the pads of the third internal data port, interconnecting half of the pads of the fourth internal data port to half of the pads of the fifth internal data port, and interconnecting the other half of the pads of the fifth internal data port to half of the pads of the sixth internal data port; and
wherein setting internal data paths in the device configuration comprises configuring the four KGDs and the DUT such that all SBD port pads on the DUT are tested simultaneously using a number of write signals equal to the number of SBD port pads on the device under test, wherein each of the KGDs receives one-fourth of the external data port write signals and transmits one-fourth of the external data port read signals, and wherein each KGD communicates SBD data with one-fourth of the SBD port pads on the DUT.

12. A semiconductor device (100) comprising:
a first data port and a second data port, each supporting simultaneous bi-directional, SBD, data transmission;
a normal data path connecting the first data port with internal circuitry of the device (100);
a pass-through path connecting the first data port with the second data port in a first correspondence of first-data-port pads to second-data-port pads;
" a test path connecting the first data port with the second data port in a second correspondence of first-data-port to second-data-port pads;
path select circuitry to select between the pass-through path and the test path; and
**characterized by**
cross-connecting switching elements that enable different correspondences between the first-data-port pads and the second-data-port pads,
wherein each data port comprises at least four pads (N0-N3, S0-S3), with their corresponding bi-directional buffers (102-0, 102-1, 102-2, 102-3, 104-0, 104-1, 104-2, 104-3).

13. The semiconductor device (100) of claim 12, wherein the pass-through path transmits data received at the first data port first pad to the second data port first pad, and vice-versa, and transmits data received at the first data port second pad to the second data port second pad, and vice-versa.

14. The semiconductor device (100) of claim 13, wherein the test path comprises a first configurable test connection that transmits data received at the first data port first pad to the second data port first pad and transmits data received at the second data port first pad to the first data port second pad.

15. The semiconductor device (100) of claim 14, wherein the test path further comprises a second configurable test connection that transmits data received at the first data port first pad to the second data port second pad and transmits data received at the second data port second pad to the first data port second pad.

16. The semiconductor device (100) of claim 12, wherein the path select circuitry comprises a set of cross-connecting switching elements (106,108) configurable to allow data to pass between the first data port pads and the second data port pads in a plurality of two-pad to one-pad mappings.

17. The semiconductor device (100) of claim 16, wherein each two-pad to one-pad mapping allows unidirectional data received and transmitted, respectively, on two pads of one of the data ports to be converted to bi-directional data received and transmitted on one pad of the other data port.

18. The semiconductor device (100) of claim 16 or 17, wherein the set of cross-connecting switching elements (106,108) are also configurable according to at least one one-pad to one-pad bi-directional mapping between the first data port pads and the second data port pads.

19. The semiconductor device (100) of claim 16, 17 or 18, each data port pad having a corresponding SBD receiver and driver, each receiver connecting to two switched paths to drivers for two data port pads on the opposite data port.

20. The semiconductor device (100) of claim 19, the path select circuitry comprising path-switching elements between the first data port and the second data port, wherein the path select circuitry further comprises a test mode register, the test mode register generating at least one test mode signal to operate path-switching elements.

## Patentansprüche

1. Verfahren zum Testen einer Vorrichtungskonfiguration mit einem externen Datenport und mindestens einem internen Datenport, worin jede Vorrichtung (100) Kreuzverbindungsschaltelemente umfasst, jeder Datenport umfasst mindestens vier Pads (N0-N3, S0-S3) mit ihren entsprechenden bidirektionalen Puffern (102-0, 102-1, 102-2, 102-3, 104-0, 104-1, 104-2, 104-3) und worin die Pads der externen und internen Datenports simultane bidirektionale (SBD) Datenübermittlung unterstützen, wobei das Verfahren umfasst:
Verbinden der Pads des externen Datenports, so dass sie mit einem Testgerät kommunizieren unter Verwendung von unidirektionaler Datenübermittlung;
Verbinden mindestens eines ersten internen Datenportpads mit einem zweiten internen Datenportpad; und
Festlegen von internen Datenpfaden in mindestens einer Vorrichtung der Vorrichtungskonfiguration zum gleichlaufend:
Leiten eines ersten Schreibsignals, das auf einem ersten externen Datenportpad empfangen ist, zu einem Ausgangstreiber des ersten internen Datenportpads,
Leiten eines zweiten Schreibsignals, das auf einem zweiten externen Datenportpad empfangen ist, zu einem Ausgangstreiber des zweiten internen Datenportpads,
Leiten eines Signals, das von einem Empfänger des ersten internen Datenportpads empfangen ist, zu einem dritten externen Datenportpad als erstes Lesesignal, und
Leiten eines Signals, das von einem Empfänger des zweiten internen Datenportpads empfangen ist, zu einem vierten externen Datenportpad als zweites Lesesignal.

2. Verfahren nach Anspruch 1, ferner umfassend Verbinden mindestens eines dritten internen Datenportpads mit einem vierten internen Datenportpad und, nach Leiten des ersten und zweiten Schreibsignals, Festlegen interner Datenpfade in mindestens einer Vorrichtung der Vorrichtungskonfiguration zum gleichlaufend:
Leiten eines dritten Schreibsignals, das auf dem ersten externen Datenportpad empfangen ist, zu einem Ausgangstreiber des dritten internen Datenportpads;
Leiten eines vierten Schreibsignals, das auf dem zweiten externen Datenportpad empfangen ist, zu einem Ausgangstreiber des vierten internen Datenportpads;
Leiten eines Signals, das von einem Empfänger des dritten internen Datenportpads empfangen ist, zum dritten externen Datenportpad als drittes Lesesignal; und
Leiten eines Signals, das von einem Empfänger des vierten internen Datenportpads empfangen ist, zum vierten externen Datenportpad als viertes Lesesignal.

3. Verfahren nach Anspruch 1 oder 2, ferner umfassend Verbinden mindestens eines dritten internen Datenportpads mit einem vierten internen Datenportpad und, als Teil des Festlegens des internen Datenpfads, Festlegen interner Datenpfade in mindestens einer Vorrichtung der Vorrichtungskonfiguration zum gleichlaufend:
Leiten eines dritten Schreibsignals, das auf einem fünften externen Datenportpad empfangen ist, zu einem Ausgangstreiber des dritten internen Datenportpads;
Leiten eines vierten Schreibsignals, das auf einem sechsten externen Datenportpad empfangen ist, zu einem Ausgangstreiber des fünften internen Datenportpads;
Leiten eines Signals, das von einem Empfänger des dritten internen Datenportpads empfangen ist, zu einem siebten externen Datenportpad als drittes Lesesignal; und
Leiten eines Signals, das von einem Empfänger des vierten internen Datenportpads empfangen ist, zu einem achten externen Datenportpad als viertes Lesesignal.

4. Verfahren nach einem der vorhergehenden Ansprüche, worin die Vorrichtungskonfiguration eine einzelne zu prüfende Vorrichtung (DUT, device under test) umfasst, die erste und zweite simultane bidirektionale (SBD) Ports aufweist:
worin der erste SBD-Port als der externe Datenport bezeichnet ist und der zweite SBD-Port als der interne Datenport bezeichnet ist; und
worin Verbinden mindestens eines ersten internen Datenportpads mit einem zweiten internen Datenportpad externes Verbinden der Hälfte der Portpads des zweiten SBD-Ports jeweils mit der anderen Hälfte der Portpads des zweiten SBD-Ports in einer solchen Konfiguration umfasst, dass keine zwei Portpads, die intern mit dem selben ersten SBD-Port verbindbar sind, extern verbunden werden.

5. Verfahren nach einem der vorhergehenden Ansprüche, worin die Vorrichtungskonfiguration erste und zweite Vorrichtungen (120, 140) umfasst, deren jede erste und zweite simultane bidirektionale (SBD) Ports aufweist:
worin der erste SBD-Port der ersten Vorrichtung (120) und der zweite SBD-Port der zweiten Vorrichtung (140) als der externe Datenport bezeichnet werden, und der zweite SBD-Port der ersten Vorrichtung (120) und der erste SBD-Port der zweiten Vorrichtung (140) jeweils als erster und zweiter interner Datenport bezeichnet werden;
worin Verbinden mindestens eines ersten internen Datenportpads mit einem zweiten internen Datenportpad miteinander Verbinden der Pads des ersten internen Datenports jeweils mit den Pads des zweiten internen Datenports umfasst; und
worin Festlegen interner Datenpfade in der Vorrichtungskonfiguration Konfigurieren der ersten und zweiten Vorrichtung derart umfasst, das die ersten und dritten externen Datenportpads dem ersten SBD-Port der ersten Vorrichtung (120) zugeordnet sind, die zweiten und vierten externen Datenportpads dem zweiten SBD-Port der zweiten Vorrichtung (140) zugeordnet sind, das erste interne Datenportpad dem ersten internen Datenport zugeordnet ist und das zweite interne Datenportpad dem zweiten internen Datenport zugeordnet ist.

6. Verfahren nach Anspruch 5, ferner umfassend Tauschen mindestens einer der ersten und zweiten Vorrichtung (120, 140) zur Position der anderen Vorrichtung in der Vorrichtungskonfiguration und Wiederholen der Schritte von Anspruch 5.

7. Verfahren nach Anspruch 5, ferner umfassend Tauschen der Positionen der ersten und zweiten Vorrichtung (120, 140) in der Vorrichtungskonfiguration und Wiederholen der Schritte von Anspruch 5.

8. Verfahren nach einem der vorhergehenden Ansprüche, worin die Vorrichtungskonfiguration erste und zweite Vorrichtungen (120, 140) umfasst, deren jede erste und zweite simultane bidirektionale (SBD) Ports aufweist, worin die erste Vorrichtung (120) eine geprüfte Vorrichtung (KGD, known good device) und die zweite Vorrichtung (140) eine zu prüfende Vorrichtung (DUT, device under test) ist,
worin der erste SBD-Port der KGD als der externe Datenport bezeichnet ist und der zweite SBD-Port der KGD und der erste und zweite SBD-Port der DUT jeweils als erster, zweiter und dritter interner Datenport bezeichnet sind;
worin Verbinden mindestens eines ersten internen Datenportpads mit einem zweiten internen Datenportpad miteinander Verbinden der Pads des ersten internen Datenports jeweils mit den Pads des zweiten internen Datenports umfasst und externes Verbinden der Hälfte der Portpads des dritten internen Datenports jeweils mit der anderen Hälfte der Portpads des dritten internen Datenports in einer solchen Konfiguration, dass keine zwei Portpads, die intern mit dem selben zweiten internen Datenportpads verbindbar sind, extern verbunden werden; und
worin Festlegen interner Datenpfade in der Vorrichtungskonfiguration Konfigurieren der ersten und zweiten Vorrichtung (120, 140) derart umfasst, dass das erste Schreibsignal vom ersten externen Datenportpad durch ein erstes Pad des ersten internen Datenports zu einem ersten Pad des zweiten internen Datenports, durch ein erstes Pad des dritten internen Datenports zu einem zweiten Pad des dritten internen Datenports, durch ein zweites Pad des zweiten internen Datenports zu einem zweiten Pad des ersten internen Datenports läuft und am vierten externen Datenportpad als das zweite Lesesignai austritt, und das zweite Schreibsignal vom zweiten externen Datenportpad durch das zweite Pad des ersten internen Datenports zum zweiten Pad des zweiten internen Datenports, durch das zweite Pad des dritten internen Datenports zum ersten Pad des dritten internen Datenports, durch das erste Pad des zweiten internen Datenports zum ersten Pad des ersten internen Datenports läuft und am dritten externen Datenportpad als das erste Lesesignal austritt.

9. Verfahren nach einem der Ansprüche 1 bis 7, worin die Vorrichtungskonfiguration erste und zweite geprüfte Vorrichtungen (KGDs) und eine zu prüfende Vorrichtung (DUT) umfasst, deren jede erste und zweite simultane bidirektionale (SBD) Ports aufweist:
worin der erste SBD-Port der ersten KGD und der zweite SBD-Port der zweiten KGD als der externe Datenport bezeichnet werden und der zweite SBD-Port der ersten KGD, der erste und zweite SBD-Port der DUT und der erste SBD-Port der zweiten KGD entsprechend als erster, zweiter, dritter und vierter interner Datenport bezeichnet werden;
worin Verbinden mindestens eines ersten internen Datenportpads mit einem zweiten internen Datenportpad miteinander Verbinden der Pads des ersten internen Datenports mit den Pads des zweiten internen Datenports umfasst und miteinander Verbinden der Pads des dritten internen Datenports mit den Pads des vierten internen Datenports; und
worin Festlegen interner Datenpfade in der Vorrichtungskonfiguration Konfigurieren der KGDs und des DUT derart umfasst, dass das erste Schreibsignal von einem ersten externen Datenportpad auf der ersten KGD durch ein erstes Pad auf dem ersten internen Datenport zu einem ersten Pad auf dem zweiten internen Datenport, durch ein erstes Pad des dritten internen Datenports zu einem ersten Pad des vierten internen Datenports läuft und durch ein viertes externes Datenportpad auf der zweiten KGD als das zweite Lesesignal austritt, und das zweite Schreibsignal von einem zweiten externen Datenportpad auf der zweiten KGD durch das erste Pad des vierten internen Datenports zum ersten Pad des dritten internen Datenports, durch das erste Pad des zweiten internen Datenports zum ersten Pad des ersten internen Datenports läuft und durch das dritte externe Datenportpad auf der ersten KGD als das erste Lesesignal austritt.

10. Verfahren nach Anspruch 9, worin das Verfahren gleichzeitig die Hälfte der Pads der zweiten und dritten internen Ports testet und das Verfahren ferner internes Rekonfigurieren mindestens der Datenpfade der ersten und zweiten KGDs umfasst, so dass die andere Hälfte der Pads der zweiten und dritten Ports gleichzeitig getestet werden.

11. Verfahren nach einem der Ansprüche 1 bis 7, worin die Vorrichtungskonfiguration erste, zweite, dritte und vierte KGDs und ein DUT umfasst, deren jedes erste und zweite SBD-Ports aufweist:
worin der erste SBD-Port der ersten KGD, erste SBD-Port der zweiten KGD, zweite SBD-Port der dritten KGD und zweite SBD-Port der vierten KGD als der externe Datenport bezeichnet werden und der zweite SBD-Port der ersten KGD, zweite SBD-Port der zweiten KGD, erste und zweite SBD-Port der DUT, erste SBD-Port der dritten KGD und erste SBD-Port der vierten KGD jeweils als erster, zweiter, dritter vierter, fünfter und sechster interner Datenport bezeichnet werden;
worin Verbinden mindestens eines internen Datenportpads mit einem zweiten internen Datenportpad miteinander Verbinden der Hälfte der Pads des ersten internen Datenports jeweils mit der Hälfte der Pads des dritten internen Datenports, Verbinden der Hälfte der Pads des zweiten internen Datenports mit der anderen Hälfte der Pads des dritten internen Datenports, Verbinden der Hälfte der Pads des vierten internen Datenports mit der Hälfte der Pads des fünften internen Datenports und Verbinden der anderen Hälfte der Pads des fünften internen Datenports mit der Hälfte der Pads des sechsten internen Datenports umfasst; und
worin Festlegen interner Datenpfade in der Vorrichtungskonfiguration Konfigurieren der vier KGDs und der DUT derart umfasst, dass alle SBD-Portpads auf der DUT gleichzeitig getestet werden unter Verwendung einer Anzahl von Schreibsignalen gleich der Anzahl von SBD-Portpads auf der zu prüfenden Vorrichtung, worin jede der KGDs ein Viertel der externen Datenportschreibsignale empfängt und ein Viertel der externen Datenportlesesignale überträgt, und worin jede KGD SBD-Daten mit einem Viertel der SBD-Portpads auf der DUT kommuniziert.

12. Halbleitervorrichtung (100) umfassend:
einen ersten Datenport und einen zweiten Datenport, deren jeder simultane bidirektionale (SBD) Datenübertragung unterstützt;
einen normalen Datenpfad, der den ersten Datenport mit interner Schaltung der Vorrichtung (100) verbindet;
einen Durchleitepfad, der den ersten Datenport mit dem zweiten Datenport in einer ersten Korrespondenz von ersten Datenportpads zu zweiten Datenportpads verbindet;
einen Testpfad, der den ersten Datenport mit dem zweiten Datenport in einer zweiten Korrespondenz von ersten Datenportpads zu zweiten Datenportpads verbindet;
Pfadauswahlschaltung zum Wählen zwischen dem Durchleitepfad und dem Testpfad; und **gekennzeichnet durch**
Kreuzverbindungsschaltelemente, die unterschiedliche Korrespondenzen zwischen den ersten Datenportpads und den zweiten Datenportpads ermöglichen,
worin jeder Datenport mindestens vier Pads (N0-N3, S0-S3) mit ihren entsprechenden bidirektionalen Puffern (102-0, 102-1, 102-2, 102-3, 104-0, 104-1, 104-2, 104-3) umfasst.

13. Halbleitervorrichtung (100) nach Anspruch 12, worin der Durchleitepfad am ersten Pad des ersten Datenports empfangene Daten zum ersten Pad des zweiten Datenports überträgt und umgekehrt, und am zweiten Pad des ersten Datenports empfangene Daten zum zweiten Pad des zweiten Datenports überträgt und umgekehrt.

14. Halbleitervorrichtung (100) nach Anspruch 13, worin der Testpfad eine erste konfigurierbare Testverbindung umfasst, die am ersten Pad des ersten Datenports empfangene Daten zum ersten Pad des zweiten Datenports überträgt und am ersten Pad des zweiten Datenports empfangene Daten zum zweiten Pad des ersten Datenports überträgt.

15. Halbleitervorrichtung (100) nach Anspruch 14, worin der Testpfad ferner einen zweite konfigurierbare Testverbindung umfasst, die am ersten Pad des ersten Datenports empfangene Daten zum zweiten Pad des zweiten Datenports überträgt und am zweiten Pad des zweiten Datenports empfangene Daten zum zweiten Pad des ersten Datenports überträgt.

16. Halbleitervorrichtung (100) nach Anspruch 12, worin die Pfadauswahlschaltung einen Satz Kreuzverbindungschaltelemente (106, 108) umfasst, die so konfigurierbar sind, dass sie ermöglichen, dass Daten zwischen ersten Datenportpads und zweiten Datenportpads in einer Mehrzahl von Zwei-Pad- und Ein-Pad-Zuordnungen laufen.

17. Halbleitervorrichtung (100) nach Anspruch 16, worin jede Zwei-Pad- zu Ein-Pad-Zuordnung ermöglicht, dass unidirektionale Daten, die jeweils auf zwei Pads von einem der Datenports empfangen und übertragen werden, in bidirektionale Daten konvertiert werden, die in einem Pad des anderen Datenports empfangen und übertragen werden.

18. Halbleitervorrichtung (100) nach Anspruch 16 oder 17, worin der Satz Kreuzverbindungschaltelemente (106, 108) auch gemäß mindestens einer Ein-Pad zu Ein-Pad bidirektionalen Zuordnung zwischen den ersten Datenportpads und den zweiten Datenportpads konfigurierbar ist.

19. Halbleitervorrichtung (100) nach Anspruch 16, 17 oder 18, worin jedes Datenportpad einen entsprechenden SBD Empfänger und Treiber aufweist, wobei jeder Empfänger zwei geschaltete Pfade zu Treibern für zwei Datenportpads auf dem gegenüberliegenden Datenport verbindet.

20. Halbleitervorrichtung (100) nach Anspruch 19, worin die Pfadauswahlschaltung Pfadschaltelemente zwischen dem ersten Datenport und dem zweiten Datenport umfasst, worin die Pfadauswahlschaltung ferner ein Testmodusregister umfasst, wobei das Testmodusregister mindestens ein Testmodussignal erzeugt, um die Pfadschaltelemente zu betätigen.

## Revendications

1. Procédé de contrôle d'une configuration de dispositifs ayant un port de données externe et au moins un port de données interne, dans lequel chaque dispositif (100) comprend des éléments de commutation d'interconnexion, chaque port de données comprend au moins quatre plages de connexion (N0-N3, S0-S3), avec leurs tampons bidirectionnels correspondants (102-0, 102-1, 102-2, 102-3, 104-0, 104-1, 104-2, 104-3), et dans lequel les plages de connexion des ports de données externe et interne(s) supportent la transmission de signaux de données SBD bidirectionnelles simultanées, le procédé comprenant :
la connexion des plages de connexion du port de données externe pour communiquer avec un contrôleur utilisant la transmission de signaux de données unidirectionnelles ;
la connexion d'au moins une première plage de connexion du port de données interne à une deuxième plage de connexion du port de données interne ; et
l'établissement de chemins de données internes dans au moins un dispositif de la configuration de dispositifs pour exécuter simultanément les opérations suivantes :
acheminer un premier signal d'écriture reçu sur une première plage de connexion du port de données externe à un circuit de commande de sortie de la plage de connexion du port de données interne,
acheminer un deuxième signal d'écriture reçu sur une deuxième plage de connexion du port de données externe à un circuit de commande de sortie de la deuxième plage de connexion du port de données interne,
acheminer un signal reçu par un récepteur de la première plage de connexion du port de données interne à une troisième plage de connexion du port de données externe en tant que premier signal de lecture, et
acheminer un signal reçu par un récepteur de la deuxième plage de connexion du port de données interne à une quatrième plage de connexion du port de données externe en tant que deuxième signal de lecture.

2. Le procédé selon la revendication 1, comprenant en outre la connexion d'au moins une troisième plage de connexion du port de données interne à une quatrième plage de connexion du port de données interne, et, après acheminement des premier et deuxième signaux d'écriture, l'établissement de chemins de données internes dans au moins un dispositif de la configuration de dispositifs pour exécuter simultanément les opérations suivantes :
acheminer un troisième signal d'écriture reçu sur la première plage de connexion du port de données externe à un circuit de commande de sortie de la troisième plage de connexion du port de données interne ;
acheminer un quatrième signal d'écriture reçu sur la deuxième plage de connexion du port de données externe à un circuit de commande de sortie de la quatrième plage de connexion du port de données interne ;
acheminer un signal reçu par un récepteur de la troisième plage de connexion du port de données interne à la troisième plage de connexion du port de données externe en tant que troisième signal de lecture ; et
acheminer un signal reçu par un récepteur de la quatrième plage de connexion du port de données interne à la quatrième plage de connexion du port de données externe en tant que quatrième signal de lecture.

3. Le procédé selon la revendication 1 ou 2, comprenant en outre la connexion d'au moins une troisième plage de connexion du port de données interne à une quatrième plage de connexion du port de données interne et, dans le cadre de l'établissement du chemin de données interne, l'établissement de chemins de données internes dans au moins un dispositif de la configuration de dispositifs pour exécuter simultanément les opérations suivantes :
acheminer un troisième signal d'écriture reçu sur une cinquième plage de connexion du port de données externe à un circuit de commande de sortie de la troisième plage de connexion du port de données interne ;
acheminer un quatrième signal d'écriture reçu sur une sixième plage de connexion du port de données externe à un circuit de commande de sortie de la quatrième plage de connexion du port de données interne ;
acheminer un signal reçu par un récepteur de la troisième plage de connexion du port de données interne à une septième plage de connexion du port de données externe en tant que troisième signal de lecture ; et
acheminer un signal reçu par un récepteur de la quatrième plage de connexion du port de données interne à une huitième plage de connexion du port de données externe en tant que quatrième signal de lecture.

4. Le procédé selon l'une quelconque des revendications précédentes, dans lequel la configuration de dispositifs comprend un seul dispositif à l'essai, DUT, ayant des premier et deuxième ports SBD bidirectionnels simultanés :
dans lequel le premier port SBD est désigné port de données externe et le deuxième port SBD est désigné port de données interne ; et
dans lequel la connexion d'au moins une première plage de connexion de port de données interne à une deuxième plage de connexion de port de données interne comprend respectivement la connexion extérieure de la moitié des plages de connexion du deuxième port SBD à l'autre moitié des plages de connexion du deuxième port SBD, dans une configuration telle qu'il n'y a pas deux plages de connexion de port connectables intérieurement au même premier port SBD qui soient connectées extérieurement.

5. Le procédé selon l'une quelconque des revendications précédentes, dans lequel la configuration de dispositifs comprend des premier et deuxième dispositifs (120, 140), ayant chacun des premier et deuxième ports SBD bidirectionnels simultanés :
dans lequel le premier port SBD du premier dispositif (120) et le deuxième port SBD du deuxième dispositif (140) sont désignés port de données externe, et le deuxième port SBD du premier dispositif (120) et le premier port SBD du deuxième dispositif (140) sont désignés respectivement premier et deuxième ports de données internes ;
dans lequel la connexion d'au moins une première plage de connexion du port de données interne à une deuxième plage de connexion du port de données interne comprend l'interconnexion des plages de connexion du premier port de données interne, respectivement, avec les plages de connexion du deuxième port de données interne ; et
dans lequel l'établissement de chemins de données internes dans la configuration de dispositifs comprend la configuration des premier et deuxième dispositifs de telle sorte que les première et troisième plages de connexion du port de données externe soient associées avec le premier port SBD du premier dispositif (120), que les deuxième et quatrième plages de connexion du port de données externe soient associées avec le deuxième port SBD du deuxième dispositif (140), que la première plage de connexion du port de données interne soit associée avec le premier port de données interne, et que la deuxième plage de connexion du port de données interne soit associée avec le deuxième port de données interne.

6. Le procédé selon la revendication 5, comprenant en outre la permutation d'au moins un des premier et deuxième dispositifs (120, 140) à la position de l'autre dispositif dans la configuration de dispositifs et la répétition des étapes de la revendication 5.

7. Le procédé selon la revendication 5, comprenant en outre la permutation des positions des premier et deuxième dispositifs (120, 140) dans la configuration de dispositifs et la répétition des étapes de la revendication 5.

8. Le procédé selon l'une quelconque des revendications précédentes, dans lequel la configuration du dispositif comprend les premier et deuxième dispositifs (120, 140), chacun ayant des premier et deuxième ports SBD bidirectionnels simultanés, dans lequel le premier dispositif (120) est un dispositif réputé bon, KGD, et le deuxième dispositif (140) est un dispositif à l'essai, DUT,
dans lequel le premier port SBD du KGD est désigné port de données externe, et le deuxième port SBD du KGD et les premier et deuxième ports SBD du DUT sont respectivement désignés premier, deuxième et troisième ports de données internes ;
dans lequel la connexion d'au moins une première plage de connexion du port de données interne à une deuxième plage de connexion du port de données interne comprend l'interconnexion des plages de connexion du premier port de donnes interne, respectivement, avec les plages de connexion du deuxième port de données interne, et la connexion externe de la moitié des plages de connexion du troisième port de données externe respectivement à l'autre moitié des plages de connexion du troisième port de données interne, dans une configuration telle qu'il n'y a pas deux plages de connexion de port connectables intérieurement à la même deuxième plage de connexion du port de données interne qui soient connectées extérieurement ; et
dans lequel l'établissement de chemins de données internes dans la configuration de dispositifs comprend la configuration des premier et deuxième dispositifs (120, 140) de telle sorte que le premier signal d'écriture passe de la première plage de connexion du port de données externe par une première plage de connexion du premier port de données interne à une première plage de connexion du deuxième port de données interne, par une première plage de connexion du troisième port de données interne à une deuxième plage de connexion du troisième port de données interne, par une deuxième plage de connexion du deuxième port de données interne à une deuxième plage de connexion du premier port de données interne, et sort de la quatrième plage de connexion du port de données externe en tant que deuxième signal de lecture, et le deuxième signal d'écriture passe de la deuxième plage de connexion du port de données externe par la deuxième plage de connexion du premier port de données interne à la deuxième plage de connexion du deuxième port de données interne, par la deuxième plage de connexion du troisième port de données interne à la première plage de connexion du troisième port de données interne, par la première plage de connexion du deuxième port de données interne à la première plage de connexion du premier port de données internes, et sort de la troisième plage de connexion du port de données externe en tant que premier signal de lecture.

9. Le procédé selon l'une quelconque des revendications 1 à 7, dans lequel la configuration de dispositifs comprend des premier et deuxième dispositifs réputés bons, KGD, et un dispositif à l'essai, DUT, chacun ayant des premier et deuxième ports SBD bidirectionnels simultanés ;
dans lequel le premier port SBD du premier KGD et le deuxième port SBD du deuxième KGD sont désignés ports de données externes, et le deuxième port SBD du premier KGD, les premier et deuxième ports SBD du DUT, et le premier port SBD du deuxième KGD sont désignés respectivement premier, deuxième, troisième et quatrième ports de données internes ;
dans lequel la connexion d'au moins une première plage de connexion du port de données interne à une deuxième plage de connexion du port de données interne comprend l'interconnexion des plages de connexion du premier port de données interne, respectivement, avec les plages de connexion du deuxième port de données interne, et l'interconnexion des plages de connexion du troisième port de données interne, respectivement, avec les plages de connexion du quatrième port de données interne ; et
dans lequel l'établissement de chemins de données internes dans la configuration de dispositifs comprend la configuration des KGD et du DUT de telle sorte que le premier signal d'écriture passe d'une première plage de connexion du port de données externe sur le premier KGD, par une première plage de connexion du premier port de données interne à une première plage de connexion du deuxième port de données interne, par une première plage de connexion du troisième port de données interne à une première plage de connexion du quatrième port de données interne, et sort par une quatrième plage de connexion du port de données externe sur le deuxième KGD lorsque le deuxième signal de lecture et le deuxième signal d'écriture passent d'une deuxième plage de connexion du port de données externe sur le deuxième KGD, par la première plage de connexion du quatrième port de données interne à la première plage de connexion du troisième port de données interne, par la première plage de connexion du deuxième port de données interne à la première plage de connexion du premier port de données interne, et sort par la troisième plage de connexion du port de données externe sur le premier KGD en tant que premier signal de lecture.

10. Le procédé selon la revendication 9, lequel procédé testant simultanément la moitié des plages de connexion des deuxième et troisième ports internes, le procédé comprenant en outre la reconfiguration interne d'au moins les chemins de données des premier et deuxième KGD pour tester simultanément l'autre moitié des plages de connexion des deuxième et troisième ports internes.

11. Le procédé selon l'une quelconque des revendications 1 à 7, dans lequel la configuration de dispositifs comprend des premier, deuxième, troisième et quatrième KGD et un DUT, chacun ayant des premier et deuxième ports SBD ;
dans lequel le premier port SBD du premier KGD, le premier port SBD du deuxième KGD, le deuxième port SBD du troisième KGD, et le deuxième port SBD du quatrième KGD sont désignés port de données externe, et le deuxième port SBD du premier KGD, le deuxième port SBD du deuxième KGD, les premier et deuxième ports SBD du DUT, le premier port SBD du troisième KGD, et le premier port SBD du quatrième KGD sont désignés respectivement premier, deuxième, troisième, quatrième, cinquième et sixième ports de données internes ;
dans lequel la connexion d'au moins une première plage de connexion du port de données interne à une deuxième plage de connexion du port de données interne comprend l'interconnexion de la moitié des plages de connexion du premier port de données interne, respectivement, avec la moitié des plages de connexion du troisième port de données interne, l'interconnexion de la moitié des plages de connexion du deuxième port de données interne à l'autre moitié des plages de connexion du troisième porte de données interne, l'interconnexion de la moitié des plages de connexion du quatrième port de données interne à la moitié des plages de connexion du cinquième port de données interne, et l'interconnexion de l'autre moitié des plages de connexion du cinquième port de données interne à la moitié des plages de connexion du sixième port de données interne ; et
dans lequel l'établissement de chemins de données internes dans la configuration de dispositifs comprend la configuration des quatre KGD et du DUT de telle sorte que toutes les plages de connexion du port SBD du DUT sont testées simultanément en utilisant un nombre de signaux d'écriture égal au nombre de plages de connexion du port SBD sur le dispositif à l'essai, dans lequel chacun des KGD reçoit un quart des signaux d'écriture du port de données externe et émet un quart des signaux de lecture du port de données externe, et dans lequel chaque KGD communique les données SBD avec un quart des plages de connexion du port SBD sur le DUT.

12. Dispositif semi-conducteur (100) comprenant :
un premier port de données et un deuxième port de données, chacun supportant la transmission de données SBD bidirectionnelle simultanée ;
un chemin de données normal connectant le premier port de données avec les circuits internes du dispositif (100) ;
un chemin direct connectant le premier port de données avec le deuxième port de données dans une première correspondance de plages de connexion de premier port de données à des plages de connexion de deuxième port de données ;
un chemin de contrôle connectant le premier port de données avec le deuxième port de données dans une deuxième correspondance de plages de connexion de premier port de données à deuxième port de données ;
des circuits de sélection de chemin pour sélectionner entre le chemin direct et le chemin de contrôle ; et
**caractérisé par**
des éléments de commutation d'interconnexion qui permettent différentes correspondances entre les plages de connexion de premier port de données et les plages de connexion de deuxième port de données,
dans lequel chaque port de donnés comprend au moins quatre plages de connexion (N0-N3, S0-S3), avec leurs tampons bidirectionnels correspondants (102-0, 102-1, 102-2, 102-3, 104-0, 104-1, 104-2, 104-3).

13. Le dispositif semi-conducteur (100) selon la revendication 12, dans lequel le chemin direct transmet les données reçues à la première plage de connexion du premier port de données à la première plage de connexion du deuxième port de données, et inversement, et transmet les données reçues à la deuxième plage de connexion du premier port de données à la deuxième plage de connexion du deuxième port de données, et inversement.

14. Le dispositif semi-conducteur (100) de la revendication 13, dans lequel le chemin de contrôle comprend une première connexion d'essai configurable qui transmet les données reçues à la première plage de connexion du premier port de données à la première plage de connexion du deuxième port de données et transmet les données reçues à la première plage de connexion du deuxième port de données à la deuxième plage de connexion du premier port de données.

15. Le dispositif semi-conducteur (100) selon la revendication 14, dans lequel le chemin de contrôle comprend en outre une deuxième connexion d'essai configurable qui transmet les données reçues à la première plage de connexion du premier port de données à la deuxième plage de connexion du deuxième port de données et transmet les données reçues à la deuxième plage de connexion du deuxième port de données à la deuxième plage de connexion du premier port de données.

16. Le dispositif semi-conducteur (100) selon la revendication 12, dans lequel les circuits de sélection de chemin comprennent un ensemble d'éléments de commutation d'interconnexion (106, 108) configurables pour permettre aux données de passer entre les premières plages de connexion de port de données et les deuxièmes plages de connexion de port de données dans une pluralité de mappages de deux plages à une plage de connexion.

17. Le dispositif semi-conducteur (100) selon la revendication 16, dans lequel chaque mappage de deux plages à une plage de connexion permet aux données unidirectionnelles reçues et transmises, respectivement, sur deux plages de connexion d'un des ports de données d'être converties en données bidirectionnelles reçues et transmises sur une plage de connexion de l'autre port de données.

18. Le dispositif semi-conducteur (100) selon la revendication 16 ou 17, dans lequel l'ensemble d'éléments de commutation d'interconnexion (106, 108) est aussi configurable conformément à au moins un mappage bidirectionnel d'une plage de connexion à une plage de connexion entre les premières plages de connexion de port de données et les deuxièmes plages de connexion de port de données.

19. Le dispositif semi-conducteur (100) selon la revendication 16, 17 ou 18, chaque plage de connexion de port de données ayant un récepteur SBD et un circuit de commande correspondants, chaque récepteur se connectant à deux chemins commutés à des circuits de commande pour deux plages de connexion de port de données sur le port de données opposé.

20. Le dispositif semi-conducteur (100) selon la revendication 19, les circuits de sélection de chemin comprenant des éléments de commutation de chemin entre le premier port de données et le deuxième port de données, dans lequel les circuits de sélection de chemin comprennent en outre un registre de mode d'essai, le registre de mode d'essai générant au moins un signal de mode d'essai pour faire fonctionner les éléments de commutation de chemin.
